# DEMANDE DE BREVET EUROPEEN

(11) **EP 2 811 427 A1**
(43) Date de publication de la demande: **10.12.2014**
(21) Numéro de dépôt: 13305764.6
(22) Date de dépôt: 07.06.2013
(51) Int. Cl.: G06K 19/077

(54) **Procédé de fabrication d'un dispositif électronique anti-fissuration**

(71) Demandeur: Gemalto SA, 92190 Meudon (FR)
(72) Inventeur: Allot, Francis, 13008 Marseille (FR); Lombardo, Sophie, 13420 Gemenos (FR); Lankinen, Mikko, 00430 Helsinki (FI); Kamagate, Youssiph, 13011 Marseille (FR); Blachon, Frédéric, 13013 Marseille (FR)

(57) **Abrégé**

L'invention concerne un procédé de fabrication d'un dispositif électronique (SM), ledit procédé comportant une étape de formation d'un corps-support (31, 32) comportant :
- une cavité (C1, C2) ménagée dans le corps- support,
- un circuit électrique (32) comportant au moins une zone d'interconnexion (Z1, Z2) électrique à l'intérieur de la cavité,
- un module électronique (17) comportant au moins une plage de connexion (10, 11) connectant ladite zone d'interconnexion, disposé dans la cavité
- un espace ou interstice (I1, I2) existant à l'interface entre le module et le corps-support, orienté sensiblement perpendiculairement à une surface principale du corps-support et débouchant en surface du corps-support ;

Le procédé se distingue en ce qu'une matière souple ou élastique est agencée dans le dispositif de manière à remplir ou recouvrir au moins partiellement ledit espace ou interstice entre le module et le corps-support.

## Description

### Domaine de l'invention.

L'invention concerne un procédé de fabrication d'un dispositif semi-fini (intermédiaire) et final, comportant notamment un corps-support avec cavité intégrant au moins une zone de connexion d'un circuit électrique / électronique.

L'invention concerne notamment le domaine des supports ou dispositifs électroniques radiofréquences tels que cartes à puce radiofréquences ou cartes hybrides, tickets ou étiquettes radiofréquences, passeports électroniques, transpondeurs radiofréquences, inserts (ou inlay) intégrant ou constituant de tels supports.

Ces supports électroniques trouvent application dans différents domaine de la carte à puce, en particulier pour des applications bancaires (EMV), d'identité, de sécurité, d'authentification, d'accès, de fidélité, passeport.

De tels supports électroniques peuvent être conformes notamment au standard ISO / IEC 14443 ou autre standard radiofréquence notamment NFC (Near field communication : champ radiofréquence de proximité)

Un module électronique peut constituer ou comprendre des plages conductrices de connexion ou d'interconnexion portées ou non, selon le cas, par un substrat isolant.

### Art antérieur.

Le brevet US 5 598 032 décrit un procédé d'assemblage d'un module destiné à se connecter à une antenne noyée dans un corps-support de carte à puce hybride (contact et sans contact), il est connu de ménager une cavité dans le corps-support de manière à rendre les zones de connexion de l'antenne accessibles pour une connexion avec le module lors de son report dans la cavité. Des éléments d'interconnexion conducteurs de toute sorte peuvent relier des plages de connexion du module disposées en dehors de l'enrobage et les zones de connexion de l'antenne.

Par ailleurs, il est connu de connecter ce type de module à une antenne localisée dans un corps de carte hybride contact et sans contact à l'aide de matière conductrice anisotropique au lieu de l'élément 24.

### Problème technique.

Actuellement, des couches de matériau fragiles utilisées comme feuille de couverture dans le corps de cartes à puce, peuvent être endommagées par des fissures qui naissent et se propagent dans la zone du module.

En outre, la connexion du module à une antenne de transpondeur disposée dans un corps support est relativement lente.

D'autre part, les assemblages existants de module dans un corps de carte peuvent donner lieu à des distorsions du support de puce (leadframe) provoquant des contraintes supplémentaires à la puce et fragilisant la fonctionnalité radiofréquence de l'ensemble.

### Résumé de l'invention.

L'invention prévoit une matière souple ou élastique qui bouche ou recouvre au moins partiellement les espaces ou interstices situés à l'interface entre le module et le corps support et adjacent de la surface du corps.

Grâce à l'invention, selon un aspect préféré, en une seule opération de connexion et une seule matière conductrice, l'invention permet de réaliser une fonction de connexion et une fonction anti-propagation de fissures après lamination.

Une matière souple ou élastique (à température ambiante) disposée à l'intérieur des fentes, permet de bloquer ou de diminuer fortement les variations de largeur des fentes ; alternativement, en chevauchant les fentes, la matière absorbe des variations / contraintes évitant ainsi de les transmettre au feuilles de couverture.

En effet, après report et pressage à chaud ou lamination, la matière conductrice flue dans les interstices. Dans le cas de l'ACF, la connexion s'effectue dans une direction perpendiculaire au plan principal du support et il n'y a pas de risque de court-circuit entre les zones de connexion du module.

Selon un autre aspect, l'invention prévoit un « patch » (pièce fine en matière souple ou élastique sous forme de film ou de pâte), qui s'étend sensiblement autour ou à l'aplomb de la zone du module rapportée au niveau de la fabrication de l'insert radiofréquence semi-fini.

La pièce souple ou élastique peut être en contact ou non avec le module ou puce pour éviter la propagation des fissures dans le corps final, soit par absorption des contraintes, soit par découplage mécanique du module avec les feuilles de couverture.

L'invention a pour objet un procédé de fabrication d'un dispositif électronique, ledit dispositif comportant :
- un corps-support muni d'une cavité,
- un circuit électrique comportant au moins une zone d'interconnexion électrique à l'intérieur de la cavité,
- un module électronique comportant au moins une plage de connexion, disposé dans la cavité et présentant une interface entre le module et la paroi de la cavité, ladite interface débouchant en surface du corps-support,
- une matière conductrice souple pour connecter ladite plage de connexion du module à ladite zone d'interconnexion ;

Le procédé se distingue en ce qu'une matière souple ou élastique est agencée dans le dispositif de manière à boucher ou recouvrir au moins partiellement les espaces ou interstices situés à l'interface entre le module et le corps support et adjacent de la surface du corps.

Selon une caractéristique ou mode de mise en oeuvre préféré, la matière souple comprend une matière conductrice de connexion agencée et compressée dans le dispositif de manière à connecter le module au circuit et à fluer dans ledit espace ou interstice pour le remplir au moins partiellement.

Selon d'autres caractéristiques ou modes de mise en oeuvre du dispositif ;
- La matière conductrice est de type anisotropique ;
- La matière anisotropique entoure le module ;
- Le dispositif comprend un patch (35), en matière souple ou élastique recouvrant l'interface ;
- Le dispositif comprend au moins une feuille de couverture (38)) dessus ou dessous ledit patch ;

L'invention a également pour objet un dispositif correspondant au procédé.

### Brève description des figures.

- Les figures 1 et 2 illustrent un exemple de module de carte à puce de circuit intégré hybride de l'art antérieur ;
- Les figures 3 et 4 illustrent une étape d'un premier mode de réalisation de l'invention respectivement en vue de dessus et en coupe A-A de la figure 4 ;
- Les figures 5A, 5B et 6 illustrent un module utilisable par l'invention avec deux répartitions différentes de la colle conductrice sur le module ;
- La figure 7 illustre le dispositif de la figure 3 après pressage à chaud ;
- La figure 8 illustre le même dispositif que celui de la figure 7 (en plus gros plan) additionné de feuilles de couvertures ;
- Les figures 9 et 10 illustrent un second et troisième mode de réalisation de l'invention.

### Description.

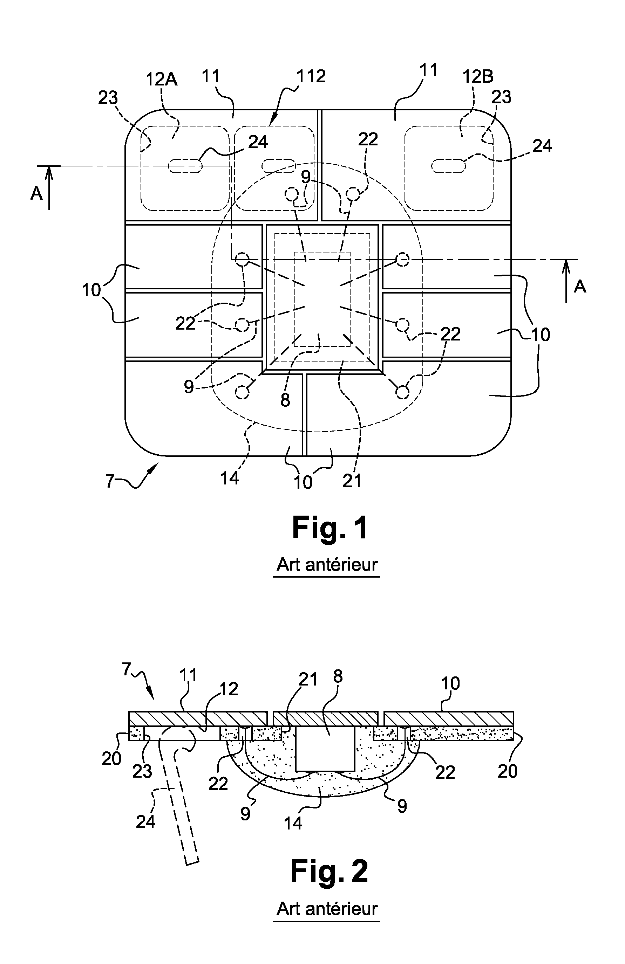

Les figures 1 et 2 illustrent un exemple de module 7 de carte à puce de circuit intégré hybride de l'art antérieur. Le module 7 comprend des plages de contact 10, 11 sur un support 20 diélectrique ou isolant notamment du type LFCC (Lead frame contrecollé), au moins une puce de circuit intégré 8 reportée sur le support 20 ou ici sur une plage métallique de contact ou non. Les plages de contact sont destinées à connecter un connecteur de lecteur de carte à puce.

Le module comprend également des connexions 9 pour notamment connecter des plages de contact par fils soudés, par colle conductrice ou autre, une puce électronique 8 (ici de type hybride) pouvant être retournée (flip-chip) ou non ; il comprend un enrobage 14 de la puce et/ou de ses connexions par une matière de protection telle une résine (glob-top).

Les connexions 9 peuvent connecter les plages de contact à travers des orifices 22 ménagés dans le support isolant.

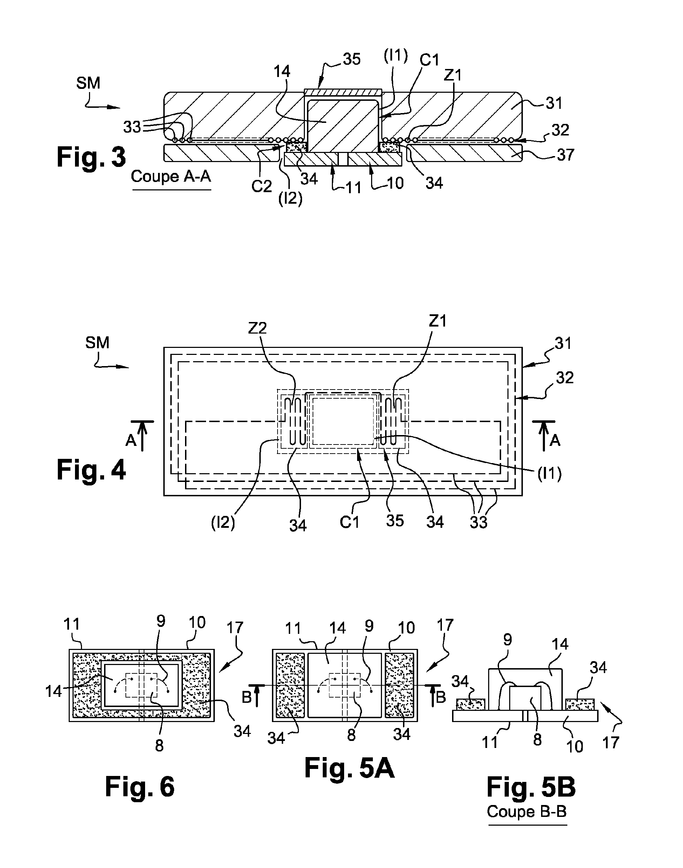

En relation avec les figures 3 à 9, on décrit un procédé de fabrication d'un dispositif électronique SM qui peut être provisoire ou définitif ; le dispositif (SM) comporte selon un premier mode de réalisation / mise en oeuvre de l'invention, une étape d'assemblage.

L'assemblage de cet exemple comporte un corps-support (31, 32) muni d'une cavité (C1, C2) et d'un circuit électrique (32) comportant au moins une zone d'interconnexion (Z1, Z2) électrique à l'intérieur de la cavité. Le dispositif comporte également dans la cavité, un module électronique /électrique (17) comportant au moins une plage de connexion (10, 11) et présentant une interface ou délimitation (I1, I2) entre le module et la paroi de la cavité ; il comporte également une matière conductrice (34) souple pour connecter ladite plage de connexion du module à ladite zone d'interconnexion (Z1, Z2) .

L'interface entre le module et le corps-support définit ici deux interstices I1, I2, orientés perpendiculairement aux surfaces principales opposées du corps-support et débouchant du corps-support.
Le corps-support peut être obtenu par exemple par moulage ou superposition de feuilles. Dans l'exemple, le dispositif est une carte purement sans-contact (radiofréquence) ayant comme circuit électrique une antenne radiofréquence 32 connectée à un module radiofréquence 17. Toutefois, le dispositif peut être alternativement un passeport électronique, une clé radiofréquence (ou NFC), un circuit imprimé, un lecteur radiofréquence, une étiquette RFID, tout objet électronique.

Le circuit électrique et/ou électronique peut être choisi parmi ou comprendre notamment une antenne, un afficheur, un capteur, un clavier, un condensateur, un interrupteur, composant électrique et/ou électronique, une batterie d'alimentation en énergie, un circuit imprimé (PCB), etc.

Dans l'exemple de la figure 3, le circuit est une antenne radiofréquence 32 composée ici de spires 33 formées sur un substrat 31 par tout moyen connu, notamment par sérigraphie, jet de matière conductrice, technique d'électrodéposition, gravure. Dans l'exemple, l'antenne est en fil incrusté par technique ultrasons sur la surface principale du substrat 31 notamment en matière plastique connue (ABS, PC, PET) ou fibreuse. Pour d'autres fréquences radiofréquences (notamment UHF), l'antenne peut présenter une forme différente des spires planes. Les zones de connexion de l'antenne sont formées par des zigzags (ou alternances rapprochés) de fils conducteurs.

L'antenne comporte des zones de connexion ou d'interconnexion Z1, Z2 espacées d'une distance correspondant aux deux plages de connexion 10, 11 du module radiofréquence (ou plots de connexion de la puce).

Dans le cas où, comme dans l'exemple, les plages sont constituées de fils conducteurs recouverts d'isolant, ce dernier peut être supprimé à l'endroit de la connexion par tout moyen connu notamment mécanique, usinage ou par laser, attaques chimiques ou thermiques.

Le substrat 31 est ici assemblé avec une feuille de compensation 37 recouvrant l'antenne. Cette feuille de compensation d'épaisseur 37 comporte une perforation ou cavité C2 centrée sur une perforation ou cavité C1 du substrat ménagée entre les zones de connexion de l'antenne.

Par ailleurs, le procédé utilise un module radiofréquence comprenant une puce radiofréquence (laquelle peut être alternativement hybride).
Le module comprend ici deux plages de connexion 10, 11 (sans support diélectrique) reliées à la puce 8 par une connexion notamment filaire 9, un enrobage 14 comme précédemment.

Selon une caractéristique de l'invention, la matière conductrice est agencée et compressée dans le dispositif de manière à fluer dans l'interface et remplir au moins partiellement l'interface (I2).

Dans l'exemple, un matériau conducteur (ou matière conductrice) 34 est placé entre les zones de connexion de l'antenne et celle du module (ou plots de la puce) avant d'effectuer la connexion par report du module.

Selon un avantage de l'invention, le matériau conducteur possède la propriété d'être plus souple que les feuilles de couverture à la température d'utilisation du produit électronique **(notamment entre - 15 °C et 60 °C).**

Cependant de préférence, on peut utiliser un matériau anisotropique, sous forme de film (ACF) ou de pâte (ACP) ou une résine conductrice souple (la souplesse étant supérieure de préférence à celle des feuilles de couverture) dans le même environnement notamment de température, pression.

Par exemple, sur les figures 5A, 5B, 6, le matériau conducteur 34 peut être disposé (agencé) ou laminé sur les plages de connexion du module (ou puce). Sur les figures 5A, 5B, le matériau est disposé sur chaque plage de connexion. Sur la figure 6, le matériau 34 en forme d'anneau entoure l'enrobage. L'épaisseur (ou volume) du matériau conducteur est calculée pour permettre un fluage du matériau dans les interstices environnants le module après assemblage final avec le corps du dispositif.

Puis le module 17 est reporté contre l'antenne, pressé et chauffé au moins sur cette zone de contact pour établir la connexion avec les plages de contact de l'antenne, la compression et le fluage de la matière conductrice dans les interstices (I1 voir I2) environnant le module, situés à l'interface entre le module et le corps du dispositif et orientés sensiblement perpendiculairement à la surface principale du corps-support.

Alternativement, le matériau conducteur 34 peut être appliqué directement sur les zones de connexion Z1, Z2 de l'antenne ; ensuite le module (ou puce) est reporté contre l'antenne, pressé et chauffé au moins sur cette zone de connexion.

Pour cette étape, deux options ci-après sont possibles. Les dimensions du film conducteur (ou pâte, matière électriquement conductrice) peuvent être ajustées aux zones de connexion de l'antenne et/ou du module. Alternativement, les dimensions du film conducteur électrique peuvent être ajustées aux dimensions du module (ou puce).

Accessoirement aussi, avant un pressage à chaud, on peut disposer un patch ou pièce de matériau élastique thermo fusible 35 contre l'arrière du module, ici contre l'enrobage 14. Ce patch recouvre dans l'exemple, toute la surface de la cavité C1 et l'interstice I1 existant entre la cavité et l'enrobage 14. Ce patch est destiné à absorber des contraintes pouvant naître à l'interface du module avec le corps-support (ou substrat) et stopper d'éventuelles propagations de fissures à des feuilles de couvertures recouvrant le corps-support 31.

Un pressage à chaud peut être réalisé au cours du report du module mais il est de préférence réalisé ultérieurement au cours d'une lamination à chaud du dispositif une fois assemblé avec des plaques ou feuilles de couverture et autre patch ou pièce d'anti-fissure comme expliqué ultérieurement. De préférence, l'assemblage s'effectue sur des plaques ou feuilles de grande dimension comportant une pluralité de modules et d'antennes de circuits électriques / électroniques. Le substrat 31 peut aussi être sous forme de bande continue, le dispositif final étant ensuite extrait par découpe du d'un substrat comportant une pluralité de dispositifs formés ensemble.

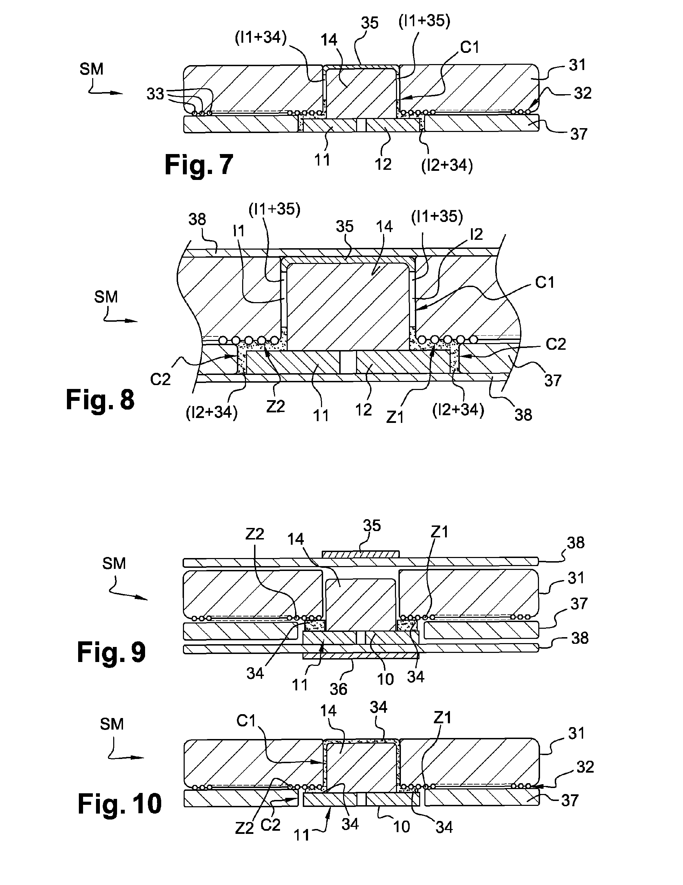

A la figure 7, le dispositif semi-fini SM est obtenu par lamination à chaud. Les interstices (I1, I2) présents entre le module 17 et la paroi interne des cavités C1, C2 sont au moins partiellement (ou en totalité) remplis par la matière conductrice élastique 34 qui a flué dedans au cours de la lamination.

Ainsi, ces interstices, responsables de la génération de fissures sur les feuilles de couverture recouvrant le corps 31 et/ou 37, peuvent être colmatés au moins partiellement avec la même matière conductrice servant à la connexion électrique du module.

Selon un aspect préféré, l'opération de connexion du module à l'antenne et l'opération de comblement au moins partiel des interstices environnant le module peuvent avantageusement s'effectuer par lamination à chaud de l'ensemble.

Par ailleurs, l'interstice I1 à l'arrière du module peut le cas échéant, être également comblé par un « patch » arrière 35 qui a aussi flué dedans.

La surface arrière de l'enrobage peut également comporter la matière élastique 35 pour absorber des compressions du module vers la surface arrière du substrat (survenant notamment au cours de flexion / torsion du dispositif final.

Ainsi, le module peut être entouré ou recouvert au moins partiellement de matière élastique absorbant les contraintes mécaniques et évitant une propagation de fissures aux feuilles de couverture.

A la figure 8, l'invention prévoit une construction similaire à la figure précédente mais avec en plus des feuilles de couverture laminées sur le dispositif SM de part et d'autre du dispositif.

A la figure 9, l'invention prévoit une construction similaire à la figure 8, à la différence que le patch 35 élastique (absorbant) est disposé à l'extérieur de la feuille de couverture recouvrant le substrat 31 du côté de l'enrobage.

Le cas échéant, ce second mode de réalisation peut comporter un autre patch élastique et thermo fusible 36 à l'aplomb des plages de contact du module ou de la cavité C2 de la feuille de compensation.

A la figure 10, la construction est similaire à celle de la figure 3 sauf que la matière conductrice 34 et le patch arrière 35 sont formés à partir d'une même pièce. Deux procédés peuvent être envisagés. Le premier consiste à recouvrir le module d'un chapeau ou d'une bande de matière conductrice 34 recouvrant les plages de contact et l'arrière de l'enrobage avant de reporter le module ainsi coiffé dans les cavités C1 et C2. Le second peut consister à placer une portion de feuille ou pièce dans la cavité C2 et de reporter ensuite par-dessus le module qui vient déformer la pièce 34 au fur et à mesure de l'insertion du module dans la cavité C1.

Ainsi, avec la même matière conductrice 34, on vient effectuer la connexion du module à l'antenne et combler au moins en partie l'interstice situé entre l'enrobage et la cavité.
Cette matière conductrice assure également la fonction anti propagation de fissure du patch 35 à l'arrière du module.

## Revendications

1. Procédé de fabrication d'un dispositif électronique (SM), ledit procédé comportant une étape de formation d'un corps-support (31, 32) comportant :
- une cavité (C1, C2) ménagée dans le corps- support,
- un circuit électrique (32) comportant au moins une zone d'interconnexion (Z1, Z2) électrique à l'intérieur de la cavité,
- un module électronique (17) comportant au moins une plage de connexion (10, 11) connectant ladite zone d'interconnexion, disposé dans la cavité
- un espace ou interstice (I1, I2) existant à l'interface entre le module et le corps-support, orienté sensiblement perpendiculairement à une surface principale du corps-support et débouchant en surface du corps-support, **caractérisé en ce qu'**une matière souple ou élastique est agencée dans le dispositif de manière à remplir ou recouvrir au moins partiellement ledit espace ou interstice entre le module et le corps-support.

2. Procédé selon la revendication précédente, **caractérisé en ce que** la matière souple comprend une matière conductrice de connexion agencée et compressée dans le dispositif de manière à connecter le module au circuit et à fluer dans ledit espace ou interstice pour le remplir au moins partiellement.

3. Procédé selon la revendication précédente, **caractérisé en ce que** la matière conductrice est de type anisotropique.

4. Procédé selon la revendication précédente, **caractérisé en ce que** la matière anisotropique entoure le module.

5. Procédé selon la revendication précédente, **caractérisé en ce qu'il** comprend un patch (35), en matière souple ou élastique recouvrant l'interface.

6. Procédé selon la revendication précédente, **caractérisé en ce qu'il** comprend au moins une feuille de couverture (38)) dessus ou dessous ledit patch.

7. Dispositif électronique (SM) comportant :
- un corps-support (31, 32)
- une cavité (C1, C2) ménagée dans le corps-support,
- un circuit électrique (32) comportant au moins une zone d'interconnexion (Z1, Z2) électrique à l'intérieur de la cavité,
- un module électronique (17) comportant au moins une plage de connexion (10, 11) connectant ladite zone d'interconnexion, disposé dans la cavité
- un espace ou interstice (I1, I2) existant à l'interface entre le module et le corps-support, orienté sensiblement perpendiculairement à une surface principale du corps-support et débouchant en surface du corps-support, **caractérisé en ce qu'il** comprend une matière souple ou élastique agencée de manière à remplir ou recouvrir au moins partiellement ledit espace ou interstice entre le module et le corps-support.

8. Dispositif selon la revendication précédente, **caractérisé en ce que** la matière souple comprend une matière conductrice de connexion agencée et compressée dans le dispositif de manière à connecter le module au circuit et à fluer dans ledit espace ou interstice pour le remplir au moins partiellement.

9. Dispositif selon la revendication précédente, **caractérisé en ce que** la matière conductrice est anisotropique.
